Europäisches Patentamt

European Patent Office

Office européen des brevets

(19)

(11) Veröffentlichungsnummer: **0 088 970**
**B1**

(12) **EUROPÄISCHE PATENTSCHRIFT**

(45) Veröffentlichungstag der Patentschrift:
05.02.86

(21) Anmeldenummer: **83102169.6**

(22) Anmeldetag: **05.03.83**

(51) Int. Cl.⁴: **G 01 N 24/08, A 61 B 5/00**

(54) **Verfahren zum Messen der magnetischen Kernresonanz für die NMR-Tomographie.**

(30) Priorität: **13.03.82  DE 3209264**

(43) Veröffentlichungstag der Anmeldung:
**21.09.83 Patentblatt 83/38**

(45) Bekanntmachung des Hinweises auf die Patenterteilung:
**05.02.86 Patentblatt 86/6**

(84) Benannte Vertragsstaaten:
**AT BE CH DE FR GB IT LI LU NL SE**

(56) Entgegenhaltungen:
**WO - A - 81/02789
DE - A - 2 540 436
US - A - 3 932 805**

**Mitteilungen der Technischen Universität
Carolo-Wilhelmina zu Braunschweig, Jahrg. XVI, Heft 1
(1981), S. 17-27**

(73) Patentinhaber: **Bruker Medizintechnik GmbH,
Silberstreifen, D-7512 Rheinstetten-Forchheim (DE)**

(72) Erfinder: **Post, Hans, Dr., Griethweg 23,
D-6905 Schriesheim (DE)**
Erfinder: **Ratzel, Dieter, Buchenweg 31,
D-7512 Rheinstetten (DE)**

(74) Vertreter: **Patentanwälte Kohler - Schwindling - Späth,
Hohentwielstrasse 41, D-7000 Stuttgart 1 (DE)**

Anmerkung  Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen  Der Einspruch ist schriftlich einzureichen und zu begründen. Er gilt erst als eingelegt. wenn die Einspruchsgebühr entrichtet worden ist (Art. 99(1) Europäisches Patentübereinkommen). ˙

**Beschreibung**

Die Erfindung betrifft ein Verfahren zum Messen der magnetischen Kernresonanz in ausgewählten Bereichen eines Körpers zum Zwecke der Bilddarstellung von Körperquerschnitten, bei dem der Körper einem homogenen statischen Magnetfeld ausgesetzt und dem homogenen Magnetfeld ein erstes Gradientenfeld in Form eines zum homogenen Magnetfeld gleich gerichteten Magnetfeldes überlagert wird, dessen Stärke sich in Richtung einer ersten Raumkoordinate des Körpers ändert, anschließend in dem Körper enthaltene, ausgewählte Kernspins, die sich in einer zur Richtung der ersten Raumkoordinate senkrecht stehenden, ausgewählten Körperebene befinden, welche durch die Larmorfrequenz der ausgewählten Kernspins in dem durch Überlagerung des homogenen Magnetfeldes und des ersten Gradientenfeldes resultierenden Magnetfeld definiert ist, mittels HF-Signalen selektiv angeregt werden, wonach ein weiteres Gradientenfeld angelegt wird, das wiederum zum homogenen Magnetfeld gleich gerichtet ist und sich in einer zur Richtung der ersten Raumkoordinate senkrechten Richtung ändert, und endlich die Induktionssignale, welche von den dem homogenen Magnetfeld und dem weiteren Gradientenfeld ausgesetzten, angeregten Kernspins geliefert werden, erfaßt und zu Bildsignalen verarbeitet werden.

Die NMR-Tomographie, auch NMR-Zeugmatographie oder NMR-Imaging genannt, ist ein in jüngster Zeit entwickeltes Verfahren zur Herstellung von Querschnittsbildern organischer Körper, die auf der Dichteverteilung bestimmter Kernarten, insbesondere der Protonen von Wasser, aber auch beispielsweise von Kohlenstoff oder Phosphor beruhen. Es ist zu erwarten, daß der NMR-Tomographie als Diagnoseverfahren in der Humanmedizin eine bedeutende Rolle zukommen wird. Die bisher bekannten Verfahren der NMR-Tomographie sind in einem Aufsatz von Hesse: "Kernresonanzbilder" in "Mitteilungen der Technischen Universität Carolo-Wilhelmina zu Braunschweig", Jahrgang XVI, Heft 1, 1981, Seiten 17-27, zusamenfassend behandelt. Inwieweit die dort erwähnten Verfahren für die Praxis Bedeutung erlangen können, hängt in hohem Maße davon ab, mit welcher Genauigkeit die einzelnen Verfahren eine selektive Anregung der für die Bilddarstellung ausgewählten Kernspins in dem einem Bildpunkt entsprechenden Volumenelement gestatten. Wenn berücksichtigt wird, daß ein solches Volumenelement je nach der gewünschten Auflösung der Bilddarstellung um 3, 4 und mehr Größenordnungen kleiner ist als das Gesamtvolumen des zu untersuchenden Körpers, so ist leicht ersichtlich, daß bei einer Selektivität der Anregung, die im Prozentbereich liegt, ein Störsignal stehen kann, das um ein Vielfaches größer ist als das eigentliche Nutzsignal.

Weiterhin spielen natürlich der zur Aufnahme eines Bildes und der damit verbundenen Datenverarbeitung erforderliche apparative Aufwand und die benötigte Meßzeit eine Rolle. In dieser Hinsicht scheint das eingangs genannte Verfahren für die praktische Anwendung geeignet, das aus einer Kombination der in dem obengenannten Aufsatz beschriebenen Anwendung geschalteter Gradienten bei selektiver Anregung und der Projektionsmethode besteht, indem durch die selektive Anregung bei Vorliegen eines Selektionsgradienten eine Körperebene ausgewählt und durch Abschalten des Selektionsgradienten und Anlegen eines Lesegradienten die Dichteverteilung der Kernspins in der ausgewählten Ebene längs des Lesegradienten ermittelt wird. Wird die Richtung des Lesegradienten in kleinen Schritten in der ausgewählten Ebene durch Drehung um die Richtung des Selektionsgradienten geändert, erhält man eine Vielzahl von Dichteverteilungen in der ausgewählten Ebene, die nach der Projektionsmethode zu einer Bilddarstellung rechnerisch kombiniert werden können.

In der Praxis bietet jedoch auch die Anwendung dieses Verfahrens noch erhebliche Probleme, weil die selektiv angeregten Spins durch Abschalten des Selektionsgradienten und Einschalten des Lesegradienten erheblich gestört werden. Diese Störung ist dadurch bedingt, daß das Schalten der Gradienten nicht unendlich schnell erfolgen kann, sondern eine endliche Zeit benötigt, während der die angeregten Spins durch das beim Schalten der Gradienten wechselnde Magnetfeld je nach ihrer Phasenlage in Bezug auf dieses Magnetfeld unterschiedlich beeinflußt werden. Diese Störung hat nicht nur eine Schwächung des Induktionssignals bei anliegendem Lesegradienten zur Folge, sondern es wird wegen der unkontrollierten Verteilung der angeregten Spins in der zur Richtung des Magnetfeldes senkrechten Ebene die Anwendung von Impulssequenzen unmöglich, wie sie sonst zur Verbesserung des Signal-Rausch-Verhältnisses angewendet werden, wie beispielsweise die Carr-Purcell-Folge.

Der Erfindung liegt demgemäß die Aufgabe zugrunde, das Verfahren der eingangs beschriebenen Art so zu verbessern, daß Störungen der angeregten Spins durch das Schalten der Gradientenfelder nicht mehr auftreten können und daher auch die ausgewählten Spins außer mit 90°-Impulsen mit speziellen Impulssequenzen angeregt werden können.

2Diese Aufgabe wird nach der Erfindung dadurch gelöst, daß bei angelegtem ersten Gradientenfeld zusätzlich zur Anregung der Kernspins in der ausgewählten Körperebene auch eine Anregung der Gesamtheit der sich innerhalb des homogenen Magnetfeldes befindenden, ausgewählten Kernsping erfolgt, wobei die selektive Anregung der in der ausgewählten Körperebene enthaltenen Kernspins einerseits und die Anregung der Gesamtheit der ausgewählten Kernspins andererseits so bemessen werden, daß die in der ausgewählten Körperebene enthaltenen, ausgewählten Kernspins parallel oder antiparallel zur Richtung des homogenen Magnetfeldes ausgerichtet werden, während die nicht in der Körperebene enthaltenen ausgewählten Kernspins gegen dieses Magnetfeld gekippt sind, daß nach Anlegen des weiteren Gradientenfeldes eine erneute Anregung der in der ausgewählten Körperebene enthaltenen, ausgewählten Kernspins derart erfolgt, daß diese Kernspins das gewünschte Induktionssignal liefern, daß wechselweise jeweils ein Induktionssignal für eine parallele und eine antiparallele Ausrichtung der Kernspins in der ausgewählten Körperebene erfaßt wird und die Bildsignale durch Subtraktion jeweils zweier solcher im Wechsel erhaltener Induktionssignale gebildet werden.

Vorzugsweise wird die Gesamtheit der Kernspins bei angelegtem ersten Gradientenfeld durch einen 90°-Impuls angeregt.

Bei dem erfindungsgemäßen Verfahren werden demnach bei herrschendem ersten Gradientenfeld, das den oben erwähnten Selektionsgradienten zur Auswahl einer Körperebene liefert, nicht nur die in der ausgewählten Ebene befindlichen Kernspins selektiv angeregt, sondern zusätzlich auch noch die im gesamten Körpervolumen enthaltenen Spins durch ein entsprechend breitbandiges Signal, so daß nach erfolgter Anregung die Kernspins, die sich in der ausgewählten Ebene befinden, zweifach angeregt worden sind, nämlich einmal selektiv und einmal zusammen mit allen anderen Kernspins des gesamten Körpers. Durch die zweifache Anregung sind die in der ausgewählten Ebene enthaltenen Kernspins in die Richtung des homogenen Magnetfeldes zurückgedreht worden, die üblicherweise als Z-Richtung bezeichnet wird, während die Spins im übrigen Volumen des Körpers aus der Z-Richtung herausgedreht sind. Bei Anwendung eines 90°-Impulses befinden sich diese Spins in der zur Richtung des homogenen Magnetfeldes senkrechten Ebene, die üblicherweise als X,Y-Ebene bezeichnet wird. Die in die X,Y-Ebene gedrehten Spins erleiden in dieser Ebene eine Dispersion, die besonders dann sehr stark ist, wenn die Dauer des Anregungssignales größer ist als die Spin-Spin-Relaxationszeit $T_2$. Diese Dispersion wird weiterhin durch das Schalten der Gradientenfelder stark gefördert, was bei dem erfindungsgemäßen Verfahren im Gegensatz zu den bekannten Verfahren durchaus erwünscht ist. Das Schalten der Gradientenfelder kann daher bewußt langsam erfolgen, was den besonderen Vorteil hat, daß keine sehr schnellen Stromwechsel erzwungen werden müssen und daher der Aufwand zum Schalten der Gradienten klein gehalten werden kann. Die in der ausgewählten Ebene enthaltenen Kernspins sind wieder in die Z-Richtung zurückgedreht und bleiben daher vom Schalten der Gradientenfelder völlig unbeeinflußt. Wenn dann nach Anlegen des weiteren Gradientenfeldes, also des Lesegradienten, eine erneute Anregung der ausgewählten Kernspins erfolgt, beispielsweise durch einen 90°-Impuls, so werden die in der ausgewählten Ebene enthaltenen Kernspins in die X, Y-Ebene gedreht und liefern in bekannter Weise das Induktionssignal, während von den übrigen Kernspins des Körpers kein Signal geliefert wird, unabhängig davon, inwieweit sie von dem 90°-Impuls beeinflußt werden, weil sich der von ihnen gelieferte Signalanteil wegen der stattgefundenen Dispersion weitgehend aufhebt. Sofern jedoch ein Restsignal vorliegt, wird es durch die erfindungsgemäße zweifache Ausführung der Messung mit Subtraktion des Induktionssignales eliminiert. Durch die gewählte Art der Anregung ist ja dafür Sorge getragen, daß die unerwünschten Signale, die von den nicht ausgewählten Kernspins geliefert werden, bei jeder Messung gleich sind, während die in der ausgewählten Ebene selektiv angeregten Kernspins abwechseln um 180° phasenverschobene Signale, also abwechselnd positive und negative Signale, liefern. Während also die gleich gerichteten Signale der unerwünschten Kernspins bei der Subtraktion eliminiert werden, werden die erwünschten Signale der ausgewählten Kernspins wegen ihrer Phasenverschiebung addiert, so daß gewährleistet ist, daß das nach der Subtraktion resultierende Induktionssignal ausschließlich von den Kernspins in der ausgewählten Ebene stammt.

Der besondere Vorteil des erfindungsgemäßen Verfahrens liegt aber nicht nur darin, daß hier eine einwandfreie Eliminierung von Signalen erzielt wird, die von Kernspins stammen, die sich nicht in dem ausgewählten Bereich des zu untersuchenden Körpers befinden, sondern daß außerdem die in dem ausgewählten Bereich enthaltenen Kernspins vom Gradientenschalten unbeeinflußt bleiben und erst dann zur Erzeugung des Induktionssignals angeregt werden, nachdem der Lesegradient eingeschaltet worden ist, so daß außer 90°-Impulsen auch Impulssequenzen zur Anregung der in der ausgewählten Ebene enthaltenen Kernspins angewendet werden können, die lange Beobachtungszeiten und dadurch eine Verbesserung des Signal-Rausch-Verhältnisses ermöglichen. Eine häufig angewandte Impulssequenz ist die Carr-Purcell-Folge, bei der einem 90°-Impuls in ausgewählten zeitlichen Abständen 180°-Impulse folgen.

Es ist zwar aus der DE-A-25 40 436 an sich bekannt, dafür Sorge zu tragen, daß die in der ausgewählten Ebene enthaltenen Kernspins während des Schaltens der Gradientenfelder in Richtung des homogenen Magnetfeldes stehen und erst nach Einschalten des Lesegradienten angeregt werden, damit sie ein Induktionssignal liefern, jedoch erfolgt bei dem bekannten Verfahren die Selektion einer Ebene des Körpers dadurch, daß alle außerhalb der Ebene vorhandenen Spins durch ein HF-Signal abgesättigt werden. In der Praxis besteht jedoch die Schwierigkeit darin, ein HF-Signal zu erzeugen, das einerseits eine einwandfreie Absättigung aller Spins außerhalb der ausgewählten Ebene gewährleistet und andererseits die innerhalb der ausgewählten Ebene angeordneten Spins nicht nachteilig beeinflußt. In der Praxis scheint es nicht möglich, ein solches Signal zu erzeugen, so daß bisher kein Gerät bekannt ist, das nach diesem Verfahren arbeitet.

Eine unzureichende Sättigung der außerhalb der ausgewählten Ebene vorhandenen Spins führt zu dem eingangs behandelten sehr großen Störsignal, während andererseits eine unerwünschte Sättigung der in der ausgewählten Ebene enthaltenen Spins zu einem Verlust an Nutzsignal führt. Die nach der Erfindung vorgesehenen Kompensations-Maßnahmen sind bei den bekannten Verfahren nicht ohne weiteres möglich. Es kann jedoch zweckmäßig sein, auch bei dem erfindungsgemäßen Verfahren nach Anlegen des ersten Gradientenfeldes den Körper einem HF-Signal auszusetzen, das annähernd eine Sättigung der sich außerhalb der ausgewählten Ebene befindenden, ausgewählten Kernspins bewirkt, bevor die Kernspins den Anregungsfeldern ausgesetzt werden, um auf diese Weise den Anteil störender Kernspins, der durch das erfindungsgemäße Verfahren beseitigt wird, von vornherein zu vermindern. Auf diese Weise kann die durch das erfindungsgemäße Verfahren gewährleistete, sehr hohe Selektion im Einzelfall ggf. noch weiter verbessert werden.

Zur Anregung der Kernspins bei anliegendem ersten Gradientenfeld kann in weiterer Ausgestaltung der Erfindung ein HF-Signal verwendet werden, das zunächst eine Drehung der in der ausgewählten Ebene angeordneten Kernspins um einen weniger als 90° betragenden Winkel $\alpha$, dann eine Drehung aller ausgewählten Kernspins um 90° und endlich wiederum eine Drehung der sich in der ausgewählten Ebene befindenden Kernspins um einen Winkel von 90°- $\alpha$ bewirkt, und zwar derart, daß die Drehungen um die Winkel $\alpha$ und (90°-$\alpha$) beide zur 90°-Drehung abwechselnd gleich und entgegengesetzt gerichtet sind. Bei einer bevorzugten Ausführungsform des erfindungsgemäßen Verfahrens betragen die Winkel $\alpha$ und (90°-$\alpha$) jeweils 45°. Dabei kann das zur Anregung der Kernspins verwendete HF-Signal entweder aus einer Folge voneinander getrennter Impulse mit verschiedenen Trägerfrequenzen und/oder Amplituden und/oder Phasen oder aber aus einem einheitlichen Impuls mit wechselnder Trägerfrequenz und/oder Amplitude und/oder Phase bestehen.

Die Anwendung eines symmetrischen Impulses oder einer symmetrischen Impulsfolge, bei der also die Winkel $\alpha$ und (90°-$\alpha$) je 45° betragen, ist im Hinblick auf eine Selbstkompensation von Fehlern besonders vorteilhaft.

Das erfindungsgemäße Verfahren ist nicht nur dazu geeignet, durch Anlegen eines Selektionsfeldes aus einem Körper eine Ebene auszuwählen, für die dann in ausgewählten Richtungen die Induktionssignale erzeugt werden, sondern es ist auch möglich, vor Anlegen des weiteren Gradientenfeldes, also des Lesefeldes, ein zweites Gradientenfeld anzulegen, also ein zweites Selektionsfeld, das ebenfalls zum homogenen Magnetfeld gleich gerichtet ist und dessen Stärke sich in einer zweiten Richtung ändert, die zu den Änderungsrichtungen des ersten und des weiteren Gradientenfeldes senkrecht steht, so daß aus der bei Anliegen des ersten Gradientenfeldes ausgewählten Ebene nach Anlegen des zweiten Gradientenfeldes durch eine erneute Anregung der Spins in der zuvor ausgewählten Ebene ein zu einem Durchmesser paralleler Streifen ausgewählt wird, in dem die Spins durch die doppelte Anregung wiederum zur Z-Richtung parallel sind, bevor das zweite Gradientenfeld abgeschaltet und das weitere Gradientenfeld oder Lesefeld eingeschaltet wird, bei dem die Anregung der ausgewählten Kernspins erfolgt. In diesem Fall liefert das Induktionssignal die Dichteverteilung längs des ausgewählten Streifens, das ohne weiteres in ein Videosignal umsetzbar ist, welches die Bildpunkte längs einer Bildzeile charakterisiert, die dem ausgewählten Streifen in der ausgewählten Ebene entspricht.

Die Erfindung wird im folgenden anhand der in der Zeichnung dargestellten Diagramme näher beschrieben und erläutert. Es zeigen

Fig. 1 eine schematische Darstellung eines zu untersuchenden Körpers in einem dem Körper zugeordneten Koordinatensystem,

Fig. 2 Zeitdiagramme, die das Anlegen verschiedener Gradientenfelder und die Zuordnung unterschiedlicher Signale veranschaulichen,

Fig. 3 und 4 Zeigerdiagramme der durch Anlegen der in Fig. 2 dargestellten Signale hervorgerufenen Drehungen von Kernspins und

Fig. 5 ein weiteres Zeitdiagramm ähnlich Fig. 2.

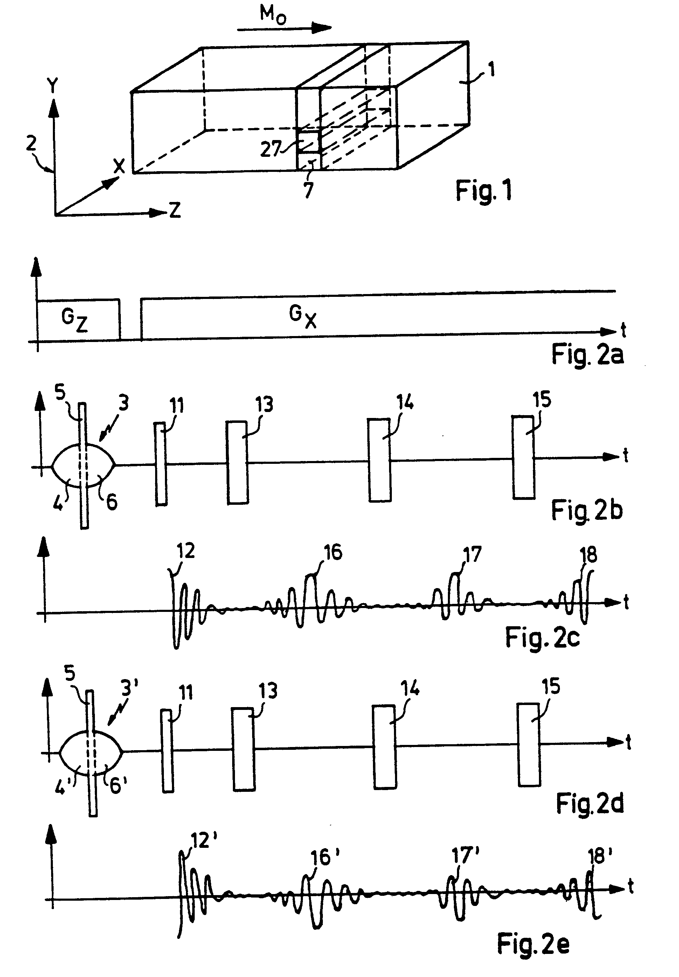

Fig. 1 zeigt einen rechteckigen Probenkörper 1 und ein zugeordnetes Koordinatensystem 2, dessen Z-Achse mit der Längenausdehnung des Körpers 1 zusammenfällt, während die X- und Y-Achsen zur Z-Achse und zueinander senkrecht stehen und die gleiche Richtung haben wie die beiden anderen Kanten des Körpers 1. Die von den X- und Y-Achsen definierte X, Y-Ebene ist daher zur Querschnittsebene des Körpers 1 parallel. Der Körper 1 ist ständig einem starken, homogenen Magnetfeld $M_0$ ausgesetzt, das sich in Richtung der Z-Achse erstreckt. Das statische, homogene Magnetfeld $M_0$ hat zur Folge, daß sich die im Körper 1 enthaltenen Kernspins parallel zur Z-Achse ausrichten, und diese Ausrichtung beibehalten, sofern sie nicht zu Präzessionsschwingungen um diese Achse angeregt werden. Diese Ausrichtung und Anregung der Kernspins sowie die Beobachtung und Auswertung der von den angeregten Kernspins gelieferten Induktionssignale sind aus der NMR-Fourier-Spektroskopie gut bekannt und brauchen hier im einzelnen nicht näher erläutert zu werden.

Zur Durchführung des erfindungsgemäßen Verfahrens wird dem homogenen Magnetfeld $M_0$ ein erstes Gradientenfeld $G_Z$ überlagert, das zum homogenen Magnetfeld $M_0$ parallel ist und dessen Stärke sich bei dem dargestellten Ausführungsbeispiel in Richtung der Z-Achse ändert, so daß die Larmorfrequenz der Kernspins sich in Richtung der Z-Achse in Abhängigkeit vom Feldgradienten ändert. Demgemäß ist jeder Querschnittsebene des Körpers 1 eine andere Larmorfrequenz eines ausgewählten Kernspins zugeordnet.

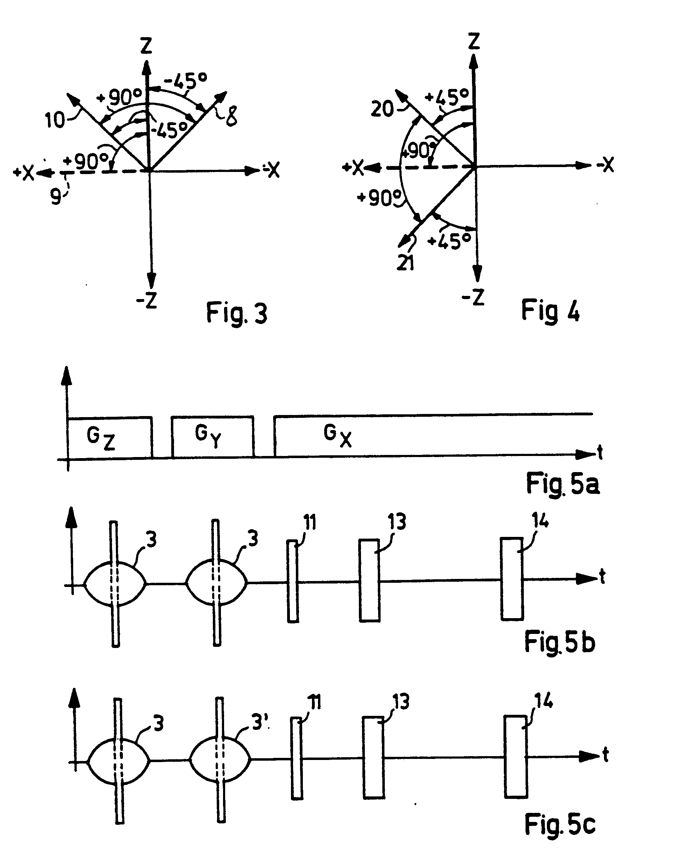

Während Anliegen des ersten Gradientenfeldes $G_Z$ (siehe Fig. 2a) wird auf den Körper 1 ein HF-Impuls 3 eingestrahlt, der aus zeitlich aufeinanderfolgenden Abschnitten 4, 5 und 6 gleicher Trägerfrequenz, jedoch unterschiedlicher Amplitude und Phase besteht. Der Abschnitt 4 des HF-Impulses 3 hat einen solchen Amplitudenverlauf, daß infolge seiner spektralen Frequenzverteilung ausgewählte Kernspins, beispielsweise Protonen, mit einer bestimmten Larmorfrequenz selektiv angeregt werden, die sich bei dem herrschenden Gredientenfeld $G_Z$ in einer ausgewählten Querschnittsebene 7 des Körpers 1 befinden, und zwar derart, daß sie in der Z, X-Ebene um -45° verdreht werden. Diese Spins nehmen dann die in Fig. 3 durch den Zeiger 8 dargestellte Lage ein. Der nachfolgende, in der Phase unterschiedliche Signalteil 5 ist so breitbandig und hat eine solche Energie, daß er allen im Körper 1 enthaltenen, ausgewählten Kernspins, also bei dem genannten Beispiel allen Protonenspins, eine Drehung in der Z, X-Ebene um +90° erteilt, so daß die sich außerhalb der ausgewählten Ebene 7 befindenden Protonen in die X-Richtung gedreht werden, wie es der Zeiger 9 in Fig. 3 veranschaulicht, während die in der Ebene 7 enthaltenen Spins von der -45°-Stellung in die +45°-Stellung verdreht werden, die der Zeiger 10 in Fig. 3 veranschsaulicht. Der letzte, zum Signalanteil 4 phasengleiche Signalanteil 6 bewirkt ebenso wie der erste Signalanteil 4 eine selektive Verdrehung der in der Ebene 7 vorhandenen, ausgewählten Spins um -45°, so daß diese Spins wieder in die Z-Richtung zurückgedreht werden, während die außerhalb der Ebene liegenden Spins 7 in der X, Y-Ebene verbleiben.

Danach wird das Gradientenfeld $G_Z$ abgeschaltet und statt dessen ein Gradientenfeld $G_X$ eingeschaltet (Fig. 2a) das ebenfalls zum homogenen Magnetfeld $M_0$ parallel ist, dessen Stärke sich jedoch in X-Richtung ändert. Da die Gradientenfelder $G_Z$ und $G_X$ parallel zum homogenen Magnetfeld $M_0$ sind, werden die zum homogenen Magnetfeld $M_0$ parallelen Kernspins in der ausgewählten Ebene 7 vom Schalten der Gradientenfelder nicht beeinflußt. Dagegen erfahren die außerhalb der Ebene 7 vorhandenen, angeregten Kernspins eine Veränderung ihrer Lage in der X, Y-Ebene durch die beim Ein- und Ausschalten der Gradientenfelder stattfindende, zeitliche Änderung des Magnetfeldes. Hierdurch wird die Verteilung dieser Kernspins auf die X,Y-Ebene, die bereits durch die normale Spin-Spin-Relaxation eintritt, in durchaus erwünschter Weise verstärkt.

Nach Anlegen des $G_X$-Gradientenfeldes werden die ausgewählten Spins des Körpers 1 mit einem 90°-Impuls 11 angeregt (siehe Fig. 2b). Hierdurch werden die ausgewählten Kernspins der Ebene 7 in die X, Y-Ebene gedreht, in der sie eine Präzessions-Bewegung ausführen, welche das in der NMR-Fourier-Spektroskopie empfangene und ausgewertete Induktionssignal 12 erzeugt (Fig. 2c). Dem 90°-Impuls können in bekannter Weise weitere Impulse 13, 14, 15 einer üblichen Impulssequenz folgen, wie sie in der NMR-Spektroskopie zur Verbesserung des Signal-Rausch-Verhältnisses angewendet wird. In Fig. 2b ist eine Carr-Purcell-Folge dargestellt, bei der dem ersten 90°-Impuls 11 eine Anzahl 180°-Impulse 13, 14, 15... folgt. Dementsprechend folgen dem ersten Induktionssignal 12 weitere Induktionssignale 16, 17, 18.., die zur Verbesserung des Signal-Rausch-Verhältnisses in bekannter Weise addiert werden.

Die außerhalb der Ebene 7 im Körper 1 enthaltenen, ausgewählten Kernspins werden durch den 90°-Impuls 11 ebenfalls beeinflußt, jedoch gemäß ihrer Phasenlage in der X, Y-Ebene unterschiedlich. Dabei wird ein Anteil in die Z-Richtung und ein anderer Anteil in die -Z-Richtung gedreht. Soweit diese Kernspins in der Z-Richtung liegen, liefern sie keinen Anteil zum Induktionssignal. Soweit sie nicht in diese Richtung zurückgedreht werden, kann wegen der Spin-Spin-Relaxation und den Störungen durch das Gradientenschalten angenommen werden, daß die Kernspins auf die X,Y-Ebene gleichmäßig verteilt waren, so daß sich ihre Signalkomponenten gegenseitig aufheben. Damit wird bereits auf diese Weise eine gute Selektion erzielt. Trotzdem ist nicht auszuschließen, daß auch die außerhalb der ausgewählten Ebene 7 liegenden Kernspins noch einen nicht unbeträchtlichen Signalanteil liefern, weil das Volumen des Körpers 1 sehr viel größer ist als das Volumen der ausgewählten Ebene 7. Um solche störenden Signalanteile zu vermeiden, sieht das erfindungsgemäße Verfahren vor, daß die soeben beschriebene Messung wiederholt wird, jedoch unter Verwendung eines Anregungssignales 3', dessen Signalanteile 4' und 6' sich von den Signalanteilen 4 und 6 des Anregungssignales 3 nach Fig. 2b dadurch unterscheiden, daß sie eine zur 90°-Drehung des Signalanteiles 5 gleich gerichtete Drehung um jeweils 45° bewirken (Fig. 2d und 4). Demgemäß werden durch den ersten Signalanteil 4' die Spins aus der Z-Richtung in der Z,X-Ebene um +45° gedreht, so daß sie in die durch den Zeiger 20 in Fig. 4 veranschaulichte Lage gebracht werden.

Bei dem anschließenden 90°-Impuls 5 werden die außerhalb der ausgewählten Ebene 7 vorhandenen Kernspins von der Z-Richtung in die +X-Richtung gebracht, wie auch bei dem vorhergehenden Experiment, während die ausgewählten Kernspins der Ebene 7 von der 45°-Stellung um 90° in die 135°-Stellung gebracht werden, die in Fig. 4 durch den Zeiger 21 veranschaulicht ist. Durch den Signalanteil 6' erfolgt dann eine weitere Drehung der ausgewählten Kernspins in der Ebene 7 um +45°, so daß diese Spins in die -Z-Richtung gelangen. Demgemäß sind die bei der folgenden Anregung durch die Impulssequenz 11, 13, 14, 15 erhaltenen Induktionssignale 12', 16', 17', 18' (Fig. 2e) zu den zuvor erhaltenen Induktionssignalen 12, 16, 17, 18 in Bezug auf den Anteil, der von den Kernspins der Ebene 7 geliefert wird, gegenphasig. Dagegen hat sich durch das geänderte Signal 3' an dem Signalanteil, der von den außerhalb der Ebene 7 gelegenen Kernspins geliefert wird, nichts geändert, so daß durch eine Subtraktion der bei den aufeinanderfolgenden Messungen erhaltenen Signale der störende Anteil der Induktionssignale, der von den außerhalb der Ebene 7 vorhandenen Kernspins stammt, eliminiert wird, während sich der Anteil des Induktionssignales, der von den Kernspins aus der Ebene 7 stammt, bei der Subtraktion addiert. Selbstverständlich könnten die Ausgangssignale 3 und 3' auch so gewählt werden, daß die gewünschten Induktionssignale gleichphasig und die Störsignale gegenphasig sind, so daß sie bei einer Addition der Signale eliminiert werden.

Durch die besondere Art der Anregung wird bei dem erfindungsgemäßen Verfahren also nicht nur von vornherein der Pegel der Störsignale kleingehalten, sondern es werden restliche Störsignale auch noch durch die Subtraktion eliminiert. Damit sind die nach der Subtraktion erhaltenen Signale von Störsignalen im wesentlichen frei und es gibt das Frequenzspektrum des erhaltenen Induktionssignals im wesentlichen die Dichteverteilung der ausgewählten Kernspins in zur Y-Richtung parallelen Streifen wieder, die in der Ebene 7 in X-Richtung aufeinanderfolgen. Werden diese Messungen unter Drehung des Koordinatennetzes um die Z-Achse wiederholt, so läßt sich aus diesen Dichteverteilungen nach der oben erwähnten Projektions-Methode die Dichte der Kernspins in einzelnen Elementen der Ebene 7 berechnen, was wiederum eine Bilddarstellung ermöglicht.

Durch selektive Anregung von Kernspins in zwei verschiedenen Gradientenfeldern besteht die Möglichkeit, die selektive Anregung der ausgewählten Kernspins auf einen ausgewählten Streifen 27 zu beschränken, der sich in der ausgewählten Ebene 7 befindet. Wie in Fig. 5 dargestellt wird zu diesem Zweck zunächst bei Anliegen eines Gradientenfeldes G$_Z$ mittels des Anregungssignales 3 dafür Sorge getragen, daß die ausgewählten Kernspins, die sich in der längs der Z-Richtung ausgewählten Ebene 7 des Körpers 1 befinden, in die Z-Richtung zurückgedreht sind, während die außerhalb dieser Ebene liegenden Kernspins in der X-, Y-Ebene verteilt sind. Danach wird das Gradientenfeld G$_Z$ abgeschaltet und durch ein Gradientenfeld G$_Y$ ersetzt, das wiederum zur Z-Achse parallel ist, dessen Feldstärke sich jedoch in Y-Richtung ändert. Durch ein weiteres Anregungssignal 3 wird nunmehr dafür Sorge getragen, daß nur noch die in einem längs der Y-Richtung ausgewählten Streifen 27 enthaltenen, ausgewählten Kernspins in die Z-Richtung zurückgedreht werden, während die außerhalb des Streifens 27 in der Ebene 7 vorhandenen Kernspins in die X, Y-Ebene gedreht worden sind. Dabei erfahren auch die außerhalb der Ebene 7 liegenden Kernspins zusätzliche Drehungen, jedoch ist dies ohne größere Bedeutung, weil, wie oben dargelegt, diese Kernspins auf die X, Y-Ebene weitgehend gleichmäßig verteilt waren und sich daher ihre Induktionssignale weitgehend kompensieren. Soweit dies nicht der Fall ist, werden sie durch die beschriebene Subtraktion eliminiert.

Nach Anregen der ausgewählten Kernspins bei anliegendem Gradientenfeld G$_Y$ wird auch dieses Gradientenfeld abgechaltet und durch das Gradientenfeld G$_X$ ersetzt, bei dem nun eine Impulssequenz 11, 13, 14.. angewendet wird, um das beschriebene Induktionssignal zu erhalten. Dieses Induktionssignal ist nun für die Dichteverteilung der ausgewählten Kernspins in dem Streifen 27 in X-Richtung charakteristisch. Das sich aus den Induktionssignalen ergebende Frequenzspektrum kann unmittelbar in die Intensität von Bildpunkten einer Bildzeile umgesetzt werden, welche dem ausgewählten Streifen 27 des Körpers 1 entspricht.

Bei der für die Signal-Subtraktion erforderlichen zweiten Messung braucht nur eines der beiden Anregungssignale, das in Fig. 5c dargestellt ist, gegenüber dem ersten entsprechenden Anregungssignal gemäß Fig. 5b verändert zu werden, um eine Umkehrung der Ausrichtung der ausgewählten Kernspins in dem ausgewählten Bereich zu erzielen, damit die Signal-Subtraktion das gewünschte Ergebnis hat. Gemäß Fig. 5c findet deshalb bei beiden aufeinanderfolgenden Messungen die Anregung bei herrschendem Gradientenfeld G$_Z$ (Fig. 5a) mit einem Anregungssignal 3 statt, bei dem die ausgewählten Kernspins in der ausgewählten Ebene 7 in gleicher Weise in die +Z-Richtung zurückgedreht werden, während bei herrschendem Gradientenfeld G$_Y$ unterschiedliche Anregungssignale 3 und 3' verwendet werden, die eine Drehung in die +Z-Richtung bzw. in die -Z-Richtung zur Folge haben. Daß bei der zweiten Messung nur eines der Anregungssignale eine Drehung in die -Z-Richtung bewirken darf beruht darauf, daß jeweils nur die Lage der ausgewählten Kernspins im ausgewählten Bereich bei Anlegen des Leseimpulses bzw. einer Impulssequenz maßgebend ist.

Wie bereits erwähnt, besteht grundsätzlich die Möglichkeit, bei angelegten Selektions-Gradientenfeldern vor Anlegen des eigentlichen Anregungssignales auf den Probekörper ein Sättigungssignal einzustrahlen, mit dem alle außerhalb des gewünschten Bereiches liegenden Kernspins abgesättigt werden. Daß es aus den eingangs genannten Gründen darauf ankommt, alle Störsignale soweit wie nur irgend möglich zu unterdrücken, und grundsätzliche keine Methode in der Lage ist, alle unerwünschten Signale restlos zu beseitigen, kann es auch zur Verbesserung der mit dem erfindungsgemäßen Verfahren erzielbaren Ergebnisse zweckmäßig sein, durch andere Methoden den möglichen Störpegel von vornherein zu senken.

Das erfindungsgemäße Verfahren läßt sich mit den bisher bekannten Einrichtungen zur NMR-Tomographie durchführen, welche die Syntheziser und Impulsgeneratoren zur Erzeugung der erforderlichen HF-Signale sowie die bekannten Einrichtungen zur Erzeugung des homogenen Magnetfeldes sowie der schaltbaren Gradientenfelder umfassen.

**Patentansprüche**

1. Verfahren zum Messen der magnetischen Kernresonanz in ausgewählten Bereichen eines Körpers zum Zwecke der Bilddarstellung von Körperquerschnitten, bei dem der Körper (1) einem homogenen statischen Magnetfeld ($M_0$) ausgesetzt und dem homogenen Magnetfeld ein erstes Gradientenfeld ($G_Z$) in Form eines zum homogenen Magnetfeld gleich gerichteten Magnetfeldes überlagert wird, dessen Stärke sich in Richtung einer ersten Raumkoordinate des Körpers ändert, anschließend in dem Körper enthaltene, ausgewählte Kernspins, die sich in einer zur Richtung der ersten Raumkoordinate senkrecht stehenden, ausgewählten Körperebene (7) befinden, welche durch die Larmorfrequenz der ausgewählten Kernspins in dem durch Überlagerung des homogenen Magnetfeldes und des ersten Gradientenfeldes resultierenden Magnetfeld definiert ist, mittels HF-Signalen selektiv angeregt werden, wonach ein weiteres Gradientenfeld ($G_X$) angelegt wird, das wiederum zum homogenen Magnetfeld gleich gerichtet ist und sich in einer zur Richtung der ersten Raumkoordinate senkrechten Richtung ändert, und endlich die Induktionssignale (12, 16, 17, 18), welche von den dem homogenen Magnetfeld und dem weiteren Gradientenfeld ausgesetzten, angeregten Kernspins geliefert werden, erfaßt und zu Bildsignalen verarbeitet werden, dadurch gekennzeichnet, daß bei angelegtem ersten Gradientenfeld ($G_Z$) zusätzlich zur anregung der Kernspins in der ausgewählten Körperebene auch eine Anregung der Gesamtheit der sich innerhalb des homogenen Magnetfeldes ($M_0$) befindenden, ausgewählten Kernspins erfolgt, wobei die selektive Anregung der in der ausgewählten Körperebene (7) enthaltenen Kernspins einerseits und die Anregung der Gesamtheit der ausgewählten Kernsping andererseits so bemessen werden, daß die in der ausgewählten Körperebene (7) enthaltenen, ausgewählten Kernspins parallel oder antiparallel zur Richtung des homogenen Magnetfeldes ($M_0$) ausgerichtet werden, während die nicht in der Körperebene (7) enthaltenen ausgewählten Kernspins gegen dieses Magnetfeld gekippt sind, daß nach Anlegen des weiteren Gradientenfeldes ($G_X$) eine erneute Anregung der In der ausgewählten Körperebene (7) enthaltenen, ausgewählten Kernspins derart erfolgt, daß diese Kernspins das gewünschte Induktionssignal (12, 16, 17, 18) liefern, daß wechselweise jeweils ein Induktionssignal für eine parallele und eine antiparallele Ausrichtung der Kernspins in der ausgewählten Körperebene erfaßt wird und die Bildsignale durch Subtraktion jeweils zweier solcher im Wechsel erhaltener Induktionssignale gebildet werden.

2. Verfahren nach Anspruch 1, dadurch gekennzeichnet, daß die Gesamtheit der Kernspins bei angelegtem ersten Gradientenfeld ($G_Z$) durch einen 90°-Impuls (5) angeregt wird.

3. Verfahren nach Anspruch 1 oder 2, dadurch gekennzeichnet, daß zur Anregung der ausgewählten Kernspins bei angelegtem weiteren Gradientenfeld ($G_X$) eine Impulsfolge (11, 13, 14, 15) verwendet wird, die für das Induktionssignal (12, 16, 17, 18) eine Verbesserung des Signal/Rausch-Verhältnisses ergibt.

4. Verfahren nach einem der vorhergehenden Ansprüche, dadurch gekennzeichnet daß nach Anlegen des ersten Gradientenfeldes der Körper einem HF-Signal ausgesetzt wird, das annähernd eine Sättigung der sich außerhalb der ausgewählten Ebene befindenden, ausgewählten Kernspins bewirkt, bevor die Kernspins den Anregungsfeldern ausgesetzt werden.

5. Verfahren nach einem der vorhergehenden Ansprüche, dadurch gekennzeichnet, daß zur Anregung der Kernspins bei anliegendem ersten Gradientenfeld ($G_Z$) ein HF-Signal (3 bzw. 3') verwendet wird, das zunächst eine Drehung der im der ausgewählten Ebene angeordneten Kernspins um einen weniger als 90° betragenden Winkel $\alpha$, dann eine Drehung der ausgewählten Kernspins um 90° und endlich wiederum eine Drehung der sich in der ausgewählten Ebene befindenden Kernspins um einen Winkel vom (90°-$\alpha$) bewirkt, und zwar derart, daß die Drehungen um die Winkel $\alpha$ und (90° - $\alpha$) beide zur 90°-Drehung abwechselnd gleich und emtgegengesetzt gerichtet sind.

6. Verfahren nach Anspruch 5, dadurch gekennzeichnet, daß die Winkel $\alpha$ und (90°-$\alpha$) je 45° betragen.

7. Verfahren nach einem der vorhergehenden Ansprüche, dadurch gekennzeichnet, daß das zur Anregung der Kernspins bei anliegendem ersten Gradientenfeld verwendete HF-Signal aus einer Folge voneinander getrennter Impulse mit verschiedenen Trägerfrequenzen, und/oder Amplituden und/oder Phasen besteht.

8. Verfahren nach einem der Ansprüche 1 bis 6, dadurch gekennzeichnet, daß das zur Anregung der Kernspins bei anliegendem ersten Gradientenfeld (G$_Z$) verwendete HF-Signal (3 bzw. 3') von einem vorzugsweise symmetrischen Impuls mit Anteilen unterschniedlicher Trägerfrequenz und/oder Amplitude und/oder Phase gebildet wird.

9. Verfahren nach einem der vorhergehenden Ansprüche, dadurch gekennzeichnet, daß vor Anlegen des weiteren Gradientenfeldes (G$_X$) ein zweites Gradientenfeld (G$_Y$) angelegt wird, das zum homogenen Magnetfeld (M$_O$) gleich gerichtet ist und dessen Stärke sich in einer zweiten Richtung (Y) ändert, die zu den Änderungsrichtungen (Z bzw. X) des ersten und des weiteren Gradientenfeldes senkrecht steht, und daß die ausgewählten Kernspins bei Anliegen des zweiten Gradientenfeldes (G$_Y$) in der gleichen Weise angeregt werden wie bei Anliegen des ersten Gradientenfeldes (G$_Z$).

## Claims

1. Method for measuring the nuclear magnetic resonance in selected areas of a body for the purpose of pictorial representation of cross sections of the body, in which the body (1) is exposed to a homogeneous static magnetic field (M$_O$) and a first gradient field (G$_Z$) in the form of a magnetic field which is unidirectional with respect to the homogeneous magnetic field is superimposed on the homogeneous magnetic field, the intensity of which gradient field changes in the direction of a first spatial coordinate of the body, then selected nuclear spins contained in the body, which are located in a selected plane (7) of the body which is arranged perpendicular to the direction of the first spatial coordinate and is defined by the Larmor frequency of the selected nuclear spins in the magnetic field resulting from superimposition of the homogeneous magnetic field and of the first gradient field, are excited selectively by means of HF-signals, whereupon a further gradient field (G$_X$) is applied, which is again unidirectional with respect to the homogeneous magnetic field and changes in a direction perpendicular to the direction of the first spatial coordinate, and finally the induction signals (12, 16, 17, 18), which are produced by the excited nuclear spins exposed to the homogeneous magnetic field and the further gradient field, are picked up and processed to form picture signals, characterised in that when the first gradient field (G$_Z$) is applied, in addition to the excitation of the nuclear spins in the selected plane of the body, an excitation of all the selected nuclear spins located within the homogeneous magnetic field (M$_O$) takes place, and this in such a way that the selective excitation of the nuclear spins contained in the selected plane (7) of the body on the one hand and the excitation of all the selected nuclear spins on the other hand are sized so that the selected nuclear spins contained in the selected plane (7) of the body are aligned parallel or antiparallel to the direction of the homogeneous magnetic field (M$_O$), whereas the selected nuclear spins not contained in the plane (7) of the body are tilted with respect to this magnetic field, that after applying the further gradient field (G$_X$), renewed excitation of the selected nuclear spins contained in the selected plane (7) of the body takes place so that these nuclear spins produce the desired induction signal (12, 16, 17, 18), and that alternately an induction signal for a parallel and antiparallel alignment of the nuclear spins in the selected plane of the body is picked up and the picture signals are formed by subtraction respectively of two such induction signals obtained alternately.

2. Method according to Claim 1, characterised in that all the nuclear spins are excited by a 90° pulse (5) when the first gradient field (G$_Z$) is applied.

3. Method according to Claim 1 or 2, characterised in that for exciting the selected nuclear spins when the further gradient field (G$_X$) is applied, a pulse train (11, 13, 14, 15) is used, which provides an improvement of the signal-to-noise ratio for the induction signal (12, 16, 17, 18).

4. Method according to one of the preceding Claims, characterised in that after applying the first gradient field, the body is subjected to an HF-signal, which almost brings about saturation of the selected nuclear spins located outside the selected plane, before the nuclear spins are exposed to the excitation fields.

5. Method according to one of the preceding Claims characterised in that an HF-signal (3, 3') is used for exciting the nuclear spins when the first gradient field (G$_Z$) is applied, which signal first of all brings about a rotation of the nuclear spins located in the selected plane by an angle α amounting to less than 90°, then a rotation of the selected nuclear spins by 90° and finally once more a rotation of the nuclear spins located in the selected plane by an angle of (90°-α) and in particular so that the rotations about the angle α and (90°-α) are both aligned with respect to the 90°-rotation alternately in the same and opposite directions.

6. Method according to Claim 5, characterised in that the angles α and (90°-α) each amount to 45°.

7. Method according to one of the preceding Claims, characterised in that the HF-signal used for exciting the nuclear spins when the first gradient field is applied consists of a train of separate pulses with different carrier frequencies and/or amplitudes and/or phases.

8. Method according to one of Claims 1 to 6, characterised in that the HF-signal (3, 3') used for exciting the nuclear spins when the first gradient field (G$_Z$) is applied is formed by a preferably symmetrical pulse with portions of different carrier frequency and/or amplitude and/or phase.

9. Method according to one of the preceding Claims, characterised in that before applying the further gradient field ($G_X$), a second gradient field ($G_Y$) is applied, which is unidirectional with respect to the homogeneous magnetic field ($M_O$) and the intensity of which changes in a second direction (Y), which is perpendicular to the directions of change (Z, X) of the first and of the furthest gradient field and that when the second gradient field ($G_Y$) is applied, the selected nuclear spins are excited in the same manner as when the first gradient field ($G_Z$) is applied.

**Revendications**

1. Procédé pour mesurer la résonnance magnétique nucléaire dans des zones déterminées d'un corps en vue de la représentation en image de sections de corps, procédé dans lequel le corps (1) est exposé à un champ magnétique statique homogène ($M_O$) et un premier champ de gradient ($G_Z$), sous forme d'un champ magnétique parallèle au champ magnétique homogène et dont l'intensité varie dans la direction d'une première coordonnée spatiale, ensuite des spins choisis contenus dans le corps, qui se trouvent dans un plan (7) du corps choisi vertical par rapport à la direction de la première coordonnée spatiale, plan qui est défini par la fréquence Larmor des spins choisis dans le champ magnétique résultant de la superposition du champ magnétique homogène et du premier champ de gradient, ces spins sont excités sélectivement au moyen de signaux HF, après quoi on applique un autre champ de gradient ($G_X$), qui est dirigé de nouveau parallèlement au champ magnétique homogène et varie dans une direction perpendiculaire à la direction de la première coordonnée spatiale, et enfin les signaux d'induction (12, 16, 17, 18), qui sont délivrés par les spins excités exposés au champ magnétique homogène et à l'autre champ de gradient, saisis et transformés en signaux images, caractérisé en ce que pendant l'application du premier champ de gradient ($G_X$), en plus de l'excitation des spins dans le plan du corps choisi, aussi la totalité des spins choisis se trouvant à l'intérieur du champ magnétique homogene ($M_O$) est excitée, operation en cours de laquelle, d'une part l'excitation sélective des spins contenus dans le plan du corps choisi (7) et d'autre part l'excitation de la totalité des spins sont réglés de façon que les spins choisis contenus dans le plan du corps (7) choisi sont parallèles ou antiparallèles à la direction du champ magnétique homogène ($M_O$), tandis que les spins choisis contenus dans le plan du corps (7) sont basculés en position oblique à ce champ magnétique;

- après application de l'autre champ de gradient ($G_X$), des spins choisis contenus dans le plan du corps choisi sont excités de nouveau de telle sorte que ces spins délivrent le signal d'induction souhaité (12, 16, 17, 18);

- alternativenent chaque fois un signal d'induction est saisi pour un alignenent parallèle et antiparallèle des spins dans le plan du corps choisi et les signaux images sont formés par soustraction à chaque fois de deux signaux d'induction en échange.

2. Procédé selon la revendication 1, caractérisé en ce que, la totalité des spins dans le premier champ de gradient ($G_Z$) appliqué est excitée par une impulsion de 90°.

3. Procédé selon la revendication 1 ou 2, caractérisé en ce que, pour l'excitatien des spins choisis dans l'autre champ appliqué de gradient ($G_X$), on utilise une suite d'impulsions (11, 13, 14, 15), qui, pour le signal d'induction (12, 16, 17, 18) produit une amélioration du rapport signal/bruit.

4. Procédé selon l'une des revendications précédentes, caractérisé en ce que, après application du premier champ de gradient, le corps est exposé à un signal HF, qui exerce approximativement une saturation des spins choisis se trouvant à l'extérieur du plan choisi, avant que les spins soient exposés aux champs d'excitation.

5. Procédé selon l'une des revendications précédentes, caractérisé en ce que, pour l'excitation des spins dans la premier champ de gradient ($G_Z$), on utilise un signal MF (3, 3'), qui effectue une rotation des spins se trouvant dans le plan choisi d'abord d'un angle $\alpha$ inférieur à 90°, puis d'un angle égal à 90° et enfin de nouveau d'un angle de (90° -$\alpha$), de sorte que les rotations des angles $\alpha$ et (90° - $\alpha$) soient dirigées alternativemant comme ou de manière opposée à la rotation de 90°.

6. Procédé selon la revendication 5, caractérisé en ce que les angles $\alpha$ et (90° - $\alpha$) sont de 45°.

7. Procédé selon l'une des revendications précédentes, caractérisé en ce que, pour l'excitation des spins dans le premier champ de gradient, le signal HF utilisé se compose d'une suite d'impulsions distinctes les unes des autres par des fréquence et/ou amplitude et/ou phase porteuses différentes.

8. Procédé selon l'une des revendications 1 à 6, caractérisé en ce que, pour l'excitation des spins dans le premier champ de gradient ($G_Z$), le signal HF (3, 3') utilisé est formé d'une impulsion de préférence symétrique avec des portions de fréquence et/ou d'amplitude et/ou de phase porteuses différentes.

9. Procédé selon l'une des revendications précédentes, caractérisé en ce que, avant l'application de l'autre champ de gradient ($G_X$), on applique un second champ de gradient ($G_Y$) qui est dirigé comme le champ magnétique homogène ($M_O$) et dont l'intensité varie dans une seconde direction Y, qui se trouve perpendiculaire aux directions de variations (Z, X) du premier et de l'autre champ de gradient, et que les spins sont excités pendant l'application du second champ de gradient ($G_Y$), de la même

manière que pendant l'application du premier champ de gradient ($G_Z$).

Fig. 1

Fig. 2a

Fig. 2b

Fig. 2c

Fig. 2d

Fig. 2e

Fig. 3

Fig 4

Fig. 5a

Fig. 5b

Fig. 5c